# EUROPEAN PATENT APPLICATION

(11) **EP 4 847 184 A1**
(43) Date of publication of application: **02.12.2026**
(21) Application number: 25744971.0
(22) Date of filing: 07.01.2025
(51) Int. Cl.: B23K 26/21, B23K 26/57, B81C 3/00, H01L 23/10

(54) **JOINING METHOD**

(30) Priority: 22.01.2024 JP 2024007196
(71) Applicant: Tazmo Co., Ltd., Okayama-shi, Okayama 701-1221 (JP)
(72) Inventor: IKAGAWA, Yoshinori, Okayama-shi, Okayama 701-1221 (JP)
(74) Representative: Knöner, Gregor
(86) International application number: PCT/JP2025/000144
(87) International publication number: WO 2025/158888

(57) **Abstract**

According to a first joining method, a first joining target and a second joining target are superposed on each other in an atmosphere at a pressure lower than a predetermined pressure. Then, a fixing part for fixing the second joining target to the first joining target is formed while the atmosphere is maintained. The fixing part is formed into a ring shape along an outer peripheral edge of the first joining target, thereby sealing the interior of the ring shape. According to a second joining method, a first joining target provided with a plurality of device regions and a second joining target are superposed on each other in an atmosphere at a pressure lower than a predetermined pressure. Then, a fixing part for fixing the second joining target to the first joining target is formed while the atmosphere is maintained. The fixing part is formed into a ring shape surrounding the plurality of device regions, thereby sealing the interior of the ring shape.

## Description

### Technical Field

The present invention relates to a joining technique using laser light.

### Background Art

In devices such as MEMS (micro electro mechanical systems), elements such as sensors (acceleration sensors, gyroscopic sensors, etc.), micromachines (actuators, etc.), or electronic circuits may be encapsulated in cavities (see Patent literature 1, for example). In a process of manufacturing such a device, using two joining targets (a joining target provided with a recess part to become a cavity and a joining target to close the recess part), these two joining targets are joined to each other after installation of the above element into the recess part, thereby forming the cavity and at the same time, encapsulating the above element in the cavity.

Meanwhile, depending on a type of the element to be encapsulated in the cavity, maintaining an internal pressure in the cavity at an appropriate value is important in terms of enhancing the performance of the element. As an example, if the element is an acceleration sensor, an internal pressure in the cavity is preferably set to a moderately low value in order to allow attenuation to be generated at the acceleration sensor using air resistance. As another example, if the element is a gyroscopic sensor, an internal pressure in the cavity is preferably set as low as possible (in other words, a degree of vacuum is preferably set as high as possible).

A method conventionally employed for setting an internal pressure in a cavity to an intended internal pressure (an appropriate value responsive to the element) includes the following.
(1) First, two joining targets are aligned with each other in terms of a positional relationship therebetween and then superposed on each other.
(2) Next, provisional joining is performed for maintaining the adjusted positional relationship.
(3) The two joining targets are thereafter introduced into a chamber, and then an internal pressure in the chamber is reduced to a pressure substantially equal to an intended internal pressure in the cavity.
(4) Then, permanent joining is performed for sealing the cavity in the chamber.

### Citation List

### Patent Literature

Patent literature 1: Japanese published unexamined patent No. 2013-251743

### Summary of Invention

### Technical Problem

According to the above conventional method, air in the cavity is caused to flow out to the outside, by means of a differential pressure resulting from reducing an internal pressure in the chamber, through a gap between joint surfaces generated by superposing the two joining targets on each other (a part except a provisionally-joined site), thereby trying to reduce an internal pressure in the cavity to an intended internal pressure.

The present inventor has found that, according to the conventional method, reducing an internal pressure in the cavity to the intended internal pressure is difficult or reducing to the intended internal pressure takes a considerably long time even if it is possible. Reason for this thought of by the present inventor is that, once the two joining targets are superposed on each other, a large flow path resistance occurs in the gap between the joint surfaces even if the differential pressure is generated, thereby imposing difficulty in causing air to flow out to the outside through the gap between the joint surfaces.

Thus, in relation to a joining method of forming a cavity by joining two joining targets to each other, it is an object of the present invention to efficiently create a state where an internal pressure in the cavity has been reduced to an intended internal pressure.

### Solution to Problem

A first joining method according to the present invention comprises a stacking step and a fixing part forming step (first aspect). In the stacking step, a first joining target and a second joining target are superposed on each other in an atmosphere at a pressure lower than a predetermined pressure. After the stacking step, in the fixing part forming step, a fixing part for fixing the second joining target to the first joining target is formed while the atmosphere is maintained. The fixing part is formed into a ring shape along an outer peripheral edge of the first joining target, thereby sealing the interior of the ring shape.

A second joining method according to the present invention comprises a stacking step and a fixing part forming step (second aspect). In the stacking step, a first joining target provided with a plurality of device regions and a second joining target are superposed on each other in an atmosphere at a pressure lower than a predetermined pressure. After the stacking step, in the fixing part forming step, a fixing part for fixing the second joining target to the first joining target is formed while the atmosphere is maintained. The fixing part is formed into a ring shape surrounding the plurality of device regions, thereby sealing the interior of the ring shape.

In the joining method according to the second aspect, each of the device regions of the first joining target may be provided with a recess part to become a cavity, and in the stacking step, an atmosphere where a pressure has been reduced to a value equal or approximate to an internal pressure intended value for the cavity (an intended internal pressure in the cavity after sealing) may be used as the atmosphere (third aspect).

According to the above first to third aspects, in the stacking step, by the simple method of superposing the two joining targets on each other in the atmosphere at a pressure lower than the predetermined pressure, the interior of the cavity formed therein before sealing can be placed at the same pressure as the pressure in the atmosphere at this moment. Moreover, by simply regulating a pressure in the atmosphere for performing the stacking step to a pressure substantially equal to the internal pressure intended value to be achieved in the cavity after sealing, a pressure in the cavity before sealing can be reduced to a value substantially equal to the internal pressure intended value. In the subsequent fixing part forming step, the fixing part is formed into the ring shape in a state where the atmosphere is maintained, thereby sealing the interior of the ring shape. By doing so, even if the joining targets are exposed to an atmosphere at the predetermined pressure (an atmospheric pressure, for example) or an atmosphere at a higher pressure, it is still possible to maintain a pressure in the ring shape at the internal pressure intended value.

A third joining method according to the present invention comprises a replacing step, a stacking step, and a fixing part forming step (fourth aspect). In the replacing step, a vacuum is generated in a chamber where a first joining target and a second joining target are located and then predetermined gas is injected into the chamber, thereby replacing the interior of the chamber with an atmosphere filled with the predetermined gas. In the stacking step, the first joining target and the second joining target are superposed on each other in the atmosphere filled with the predetermined gas. After the stacking step, in the fixing part forming step, a fixing part for fixing the second joining target to the first joining target is formed while the atmosphere is maintained. The fixing part is formed into a ring shape along an outer peripheral edge of the first joining target, thereby sealing the interior of the ring shape.

A fourth joining method according to the present invention comprises a replacing step, a stacking step, and a fixing part forming step (fifth aspect). In the replacing step, a vacuum is generated in a chamber where a first joining target provided with a plurality of device regions and a second joining target are located and then predetermined gas is injected into the chamber, thereby replacing the interior of the chamber with an atmosphere filled with the predetermined gas. In the stacking step, the first joining target and the second joining target are superposed on each other in the atmosphere filled with the predetermined gas. After the stacking step, in the fixing part forming step, a fixing part for fixing the second joining target to the first joining target is formed while the atmosphere is maintained. The fixing part is formed into a ring shape surrounding the plurality of device regions, thereby sealing the interior of the ring shape.

According to the above fourth or fifth aspect, by injecting the predetermined gas into the chamber after a vacuum is generated in the chamber in the replacing step, the interior of the chamber is replaced easily with an atmosphere containing the predetermined gas as a main component. Then, in the stacking step, by the simple method of superposing the two joining targets on each other in the resultant atmosphere filled with the predetermined gas, a state filled with the same gas as that in the atmosphere at this moment can be created in the cavity before sealing formed therein. Moreover, by simply selecting a type of the gas for filling the interior of the chamber, a state filled with desired gas can be created in the cavity before sealing. In the subsequent fixing part forming step, the fixing part is formed into the ring shape in a state where the atmosphere is maintained, thereby sealing the interior of the ring shape. By doing so, even if the joining targets are exposed to air, it is still possible to maintain the interior of the ring shape in a state filled with the desired gas.

In the joining method according to any one of the second, third, and fifth aspects, the second joining target may be provided with device regions corresponding to the device regions of the first joining target, and in the stacking step, position alignment may be made on at least one of the first joining target and the second joining target in order for the respective positions of the corresponding device regions to be matched with each other, and the second joining target may be superposed on the first joining target after the alignment (sixth aspect).

According to the above sixth aspect, in a case where interconnect lines, electrodes, or the like are formed at both of the two corresponding device regions, such interconnect lines or electrodes can be adjusted in terms of a positional relationship therebetween in order to be electrically connected to each other correctly during joining.

The joining method according to any one of the first to sixth aspects may include a configuration as follows (seventh aspect). The joining method may further comprise a metal layer forming step as a step performed before the stacking step. The metal layer forming step forms a metal layer on at least one of a joint surface of the first joining target and a joint surface of the second joining target. In the fixing part forming step, laser light may be applied locally to the metal layer provided between the first joining target and the second joining target, so that a site applied with the laser light is heated locally to form the fixing part with the ring shape.

According to the above seventh aspect, at a site applied with the laser light (a site where the fixing part is planned to be formed), it is possible to melt the metal layer together with the first joining target and the second joining target or diffuse metal as a main component of the metal layer into the first joining target and the second joining target. As a result, a compound (such as metal silicide) or an alloy (such as an alloy of metal and Si) between the metal and a main component (such as semiconductor) of each of the first joining target and the second joining target is formed at an interface between the metal layer and each of the first joining target and the second joining target. In other words, it is possible to form the fixing part for firmly coupling the first joining target and the second joining target to each other. The resultant fixing part is formed into the ring shape in an atmosphere at a pressure lower than the predetermined pressure, so that the interior of the ring shape can be sealed reliably while being maintained at the lower pressure than the predetermined pressure.

A fifth joining method according to the present invention comprises a provisional joining step and a permanent joining step (eighth aspect). In the provisional joining step, provisional joining is performed between a first joining target and a second joining target using the joining method according to any one of the above first to seventh aspects. After the provisional joining step, in the permanent joining step, the first joining target and the second joining target are fixed further to each other in a region inside the ring shape of the
fixing part. At this time, the permanent joining step is performed using a chamber different from a chamber used for implementation of the provisional joining step.

In the provisional joining step, a state where the interior of the cavity (the cavity before sealing) has been reduced to the internal pressure intended value can be created efficiently as described above. Thus, in the permanent joining step, it is possible to easily provide the cavity (the cavity after sealing) where an internal pressure is maintained at an appropriate value (the internal pressure intended value) simply by performing joining for sealing the cavity (the cavity before sealing).

According to the above eighth aspect, the permanent joining step is performed using a chamber different from the chamber having been used for implementation of the provisional joining step. This makes it possible to shorten cycle time required for processes (provisional joining and permanent joining) on one set of joining targets. This will be described below in detail.

Both the stacking step (a step where an atmosphere at a pressure lower than the predetermined pressure (an atmosphere where a degree of vacuum is high, for example) is required to be created) of the provisional joining step and the permanent joining step are processes to take time. Here, it is assumed that the provisional joining step and the permanent joining step are performed sequentially in one chamber. In this case, a transition to the processes on a next set of joining targets can be made only after the processes on one set of joining targets are finished, leading to longer cycle time required for the processes (provisional joining and permanent joining) on one set of joining targets.

By contrast, according to the above eighth aspect, by performing the permanent joining step using a chamber different from the chamber used for implementation of the provisional joining step, it becomes possible to perform these steps in parallel using a plurality of chambers. As a result, cycle time required for the processes (provisional joining and permanent joining) on one set of joining targets can be shortened.

### Advantageous Effects of Invention

According to the present invention, it is possible to efficiently create a state where an internal pressure in the cavity has been reduced to the intended internal pressure.

### Brief Description of Drawings

FIG. 1 is a conceptual view showing a provisional joining step in a process sequence performed in an embodiment.
FIG. 2 is a conceptual view showing a continuation of the provisional joining step from FIG. 1 in a process sequence.
FIGS. 3A and 3B are plan views illustrating a first joining target and a second joining target respectively prepared in a preparing step.
FIG. 4 is a plan view illustrating a planned formation pattern of a fixing part used in the provisional joining step.
FIG. 5 is a conceptual view showing a permanent joining step in a process sequence performed in the embodiment.
FIG. 6 is a plan view illustrating a planned formation pattern of a fixing part used in the permanent joining step.
FIGS. 7A and 7B are plan views showing two examples of a planned formation pattern of a fixing part used in a provisional joining step according to a first modification.
FIGS. 8A and 8B are plan views showing other two examples of the planned formation pattern of the fixing part used in the provisional joining step according to the first modification.
FIG. 9 is a conceptual view showing a provisional joining step in a process sequence performed in a second modification.
FIG. 10 is a conceptual view showing a continuation of the provisional joining step from FIG. 9 in a process sequence.
FIG. 11 is a conceptual view showing a permanent joining step in a process sequence performed in the second modification.

### Description of Embodiments

A joining method according to the present invention is a method of joining two joining targets (such as semiconductor wafers and will be called a "first joining target W1" and a "second joining target W2") to each other. The joining method according to the present invention will be described below in detail by providing an embodiment and modifications thereof. The joining method described below can be implemented using various types of known apparatuses.

### [1] Embodiment

The joining method according to the present embodiment is broadly divided into two joining steps to be performed sequentially as steps for joining the first joining target W1 and the second joining target W2 to each other. More specifically, a provisional joining step S1 is performed as a first joining step, and a permanent joining step S2 is performed thereafter as a second joining step. These joining steps will be described below in detail.

### [1-1] Provisional Joining Step

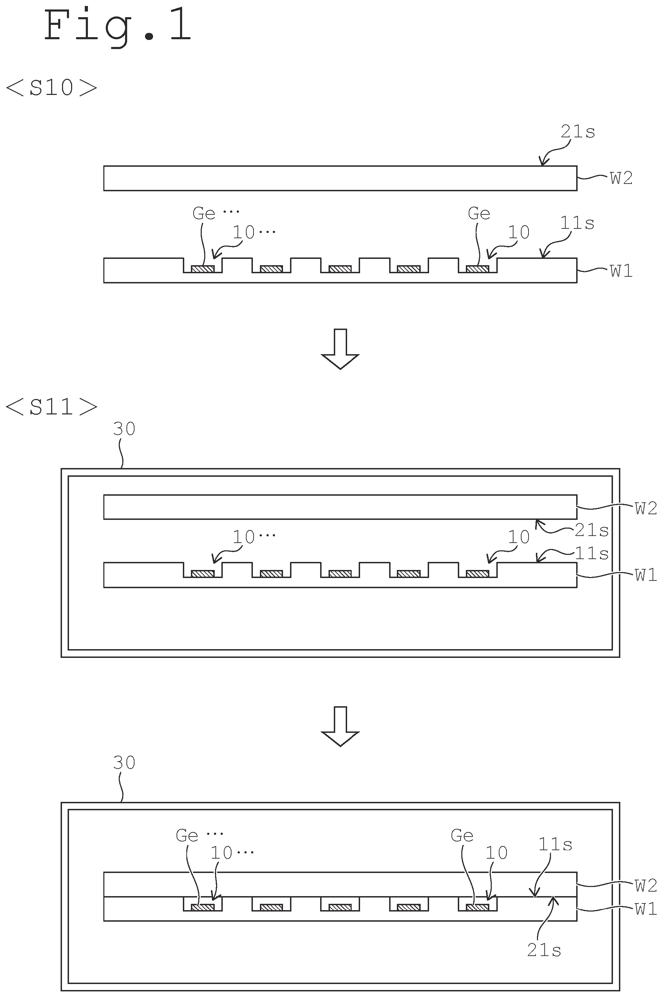

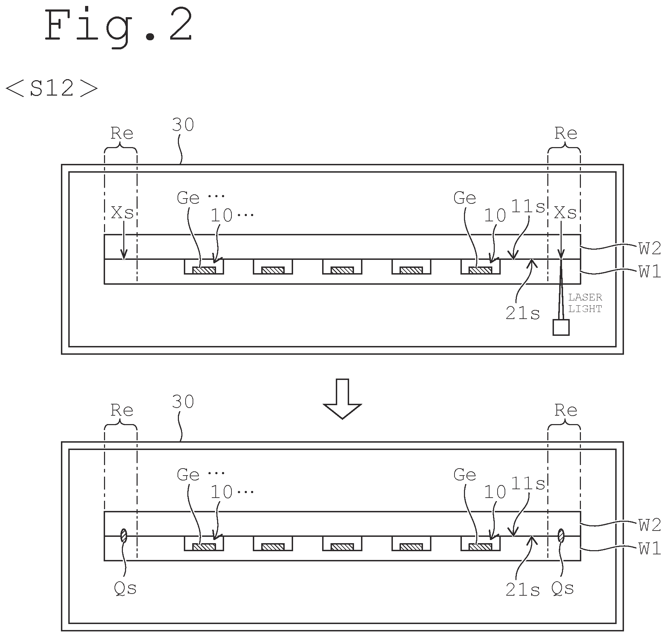

FIGS. 1 and 2 are conceptual views showing the provisional joining step S1 in a process sequence performed in the present embodiment. In the provisional joining step S1, a preparing step S10, a stacking step S11, and a fixing part forming step S12 are performed in this sequence.

### <Preparing step S10>

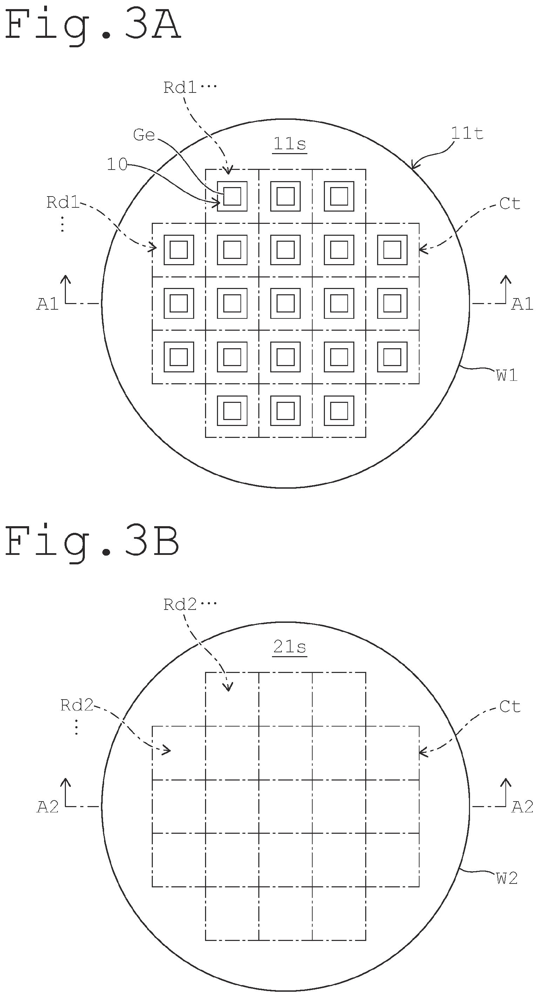

In the preparing step S10, the first joining target W1 and the second joining target W2 are prepared. FIGS. 3A and 3B are plan views illustrating the first joining target W1 and the second joining target W2 respectively prepared in the preparing step S10. The first joining target W1 and the second joining target W2 in FIGS. 1 and 2 are shown in sections along an A1-A1 line and an A2-A2 line identified in FIGS. 3A and 3B respectively. This also applies to other drawings showing corresponding steps.

In the present embodiment, the first joining target W1 has a plurality of device regions Rd1 to be singulated individually by cutting along a cutting line Ct (see FIG. 3A), and the second joining target W2 has a device region Rd2 corresponding to each device region Rd1 of the first joining target W1 (see FIG. 3B). One set of the corresponding device regions Rd1 and Rd2 is cut along the cutting line Ct after joining to be singulated individually, thereby forming one device.

More specifically, each device region Rd1 of the first joining target W1 is a part to become a base of the device, and each device region Rd1 is provided with a recess part 10 to become an enclosed space (a cavity) for encapsulating an element Ge to fulfill the function of the device. Here, the element Ge is a sensor (such as an acceleration sensor or a gyroscopic sensor), a micromachine (such as an actuator), or an electronic circuit, for example. In the present embodiment, the element Ge is an element for which maintaining an internal pressure in the cavity at an appropriate value is important in terms of enhancing the performance of the element Ge.

Each device region Rd2 of the second joining target W2 is a region to close the recess part 10 in the device region Rd1 of the first joining target W1, and is a part to become a lid of the device.

Furthermore, the device regions Rd1 and Rd2 are provided with respective interconnect lines, electrodes, or the like (not shown in the drawings) to be connected to each other. During joining, these interconnect lines or electrodes are required to be electrically connected to each other correctly.

### <Stacking Step S11>

In the stacking step S11, using the first joining target W1 and the second joining target W2 prepared in the preparing step S10, the second joining target W2 is superposed on the first joining target W1 in an atmosphere at a pressure lower than a predetermined pressure Pt. Here, the predetermined pressure Pt is a pressure for an atmosphere to be used in the permanent joining step S2 described later. While not particularly limited, the predetermined pressure Pt is an atmospheric pressure, for example.

More specifically, first, the first joining target W1 and the second joining target W2 are introduced into a chamber 30 where an internal pressure can be regulated. At this time, the first joining target W1 and the second joining target W2 are located in the chamber 30 with respective joint surfaces 11s and 21s thereof facing each other and being separated from each other (see an upper view of S11 shown in FIG. 1). Here, the joint surfaces 11s and 21s are surfaces to be joined to each other in each of the provisional joining step S1 and the permanent joining step S2. The recess part 10 is exposed in the joint surface 11s, and the interconnect lines, the electrodes, or the like to be connected to each other are exposed on the joint surfaces 11s and 21s.

Next, an internal pressure in the chamber 30 is reduced to create an atmosphere, which is to be employed as an atmosphere in the chamber 30 (an atmosphere at a pressure lower than the predetermined pressure Pt), where a pressure has been reduced to a value equal or approximate to an internal pressure intended value Px for the above cavity (the enclosed space for encapsulating the element Ge).

Furthermore, in the present embodiment, position alignment is made on at least one of the first joining target W1 and the second joining target W2 in order for the respective positions of the corresponding device regions Rd1 and Rd2 to be matched with each other in the stacking step S11. More specifically, a positional relationship between the interconnect lines, the electrodes, or the like formed in the corresponding device regions Rd1 and Rd2 is adjusted by the alignment in order for the interconnect lines or the electrodes to be electrically connected correctly during joining.

Then, while the positional relationship after the alignment is maintained, the second joining target W2 is superposed on the first joining target W1 (see a lower view of S11 shown in FIG. 1).

According to the described stacking step S11, by the simple method of superposing the two joining targets (the first joining target W1 and the second joining target W2) on each other in the atmosphere at a pressure lower than the predetermined pressure Pt, the interior of the cavity formed therein before sealing can be placed at the same pressure as the pressure in the atmosphere at this moment. Moreover, by simply regulating a pressure in the atmosphere for performing the stacking step S11 to a pressure substantially equal to the internal pressure intended value Px to be achieved in the cavity after sealing, a pressure in the cavity before sealing can be reduced to a value substantially equal to the internal pressure intended value Px. By doing so, it becomes possible to efficiently create a state where an internal pressure in the cavity (here, the cavity before sealing) has been reduced to an intended internal pressure (the internal pressure intended value Px). In this way, according to the stacking step S11, it is possible to efficiently control an internal pressure in the cavity before sealing.

As the interconnect lines, the electrodes, or the like formed in the corresponding two device regions Rd1 and Rd2 are regulated in terms of a positional relationship therebetween by the above alignment, they are to be electrically connected to each other correctly when the second joining target W2 is superposed on the first joining target W1.

### <Fixing Part Forming Step S12>

In the fixing part forming step S12, while the atmosphere in the chamber 30 is maintained as it is (in other words, while the pressure regulated in the stacking step S11 is maintained), a fixing part Qs for fixing the second joining target W2 to the first joining target W1 is formed into a ring shape (a closed ring shape) along an outer peripheral edge 11t of the first joining target W1, thereby sealing the interior of the ring shape.

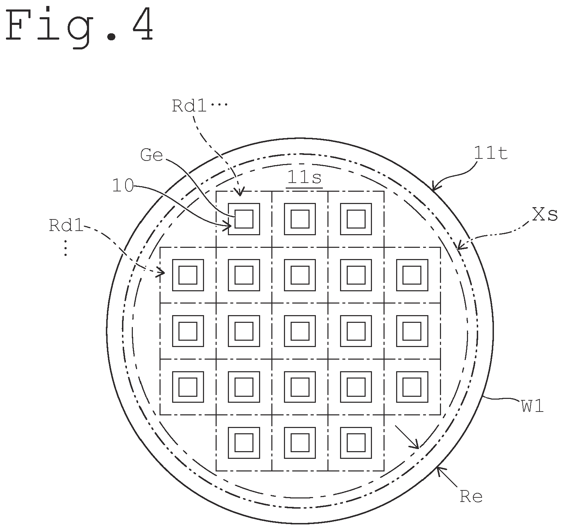

More specifically, laser light is applied locally to an interface (a contact surface) between the joint surfaces 11s and 21s (see an upper view of S12 shown in FIG. 2), so that a site applied with the laser light is heated locally to be melted or altered. By doing so, the joint surfaces 11s and 21s are fixed to each other at the local site (see a lower view of S12 shown in FIG. 2). At this time, the first joining target W1 and the second joining target W2 may be interposed under pressure using quartz plates, for example, in order to increase a degree of tight contact between the joint surfaces 11s and 21s. Then, scan is performed with laser light along a pattern of the closed ring shape (a planned formation pattern Xs of the fixing part Qs, see FIG. 4), thereby fixing the joint surfaces 11s and 21s to each other along the pattern. In this way, the fixing part Qs with the closed ring shape is formed.

FIG. 4 is a plan view illustrating the planned formation pattern Xs of the fixing part Qs. In the example in FIG. 4, the first joining target W1 has a circular plate shape, and has a peripheral portion Re where the planned formation pattern Xs is defined into a circular ring shape along the outer peripheral edge 11t. With such shapes, the planned formation pattern Xs is defined into a ring shape surrounding all the device regions Rd1 of the first joining target W1.

According to the described fixing part forming step S12, in a state where the atmosphere in the chamber 30 is maintained (in other words, in a state where the pressure regulated in the stacking step S11 is maintained), the fixing part Qs is formed into the ring shape (the closed ring shape), thereby sealing the interior of the ring shape. By doing so, even if the first joining target W1 and the second joining target W2 after the provisional joining are exposed to an atmosphere at the predetermined pressure Pt (an atmospheric pressure, for example) or an atmosphere at a higher pressure, it is still possible to maintain a pressure in the ring shape at the internal pressure intended value Px.

### [1-2] Permanent Joining Step

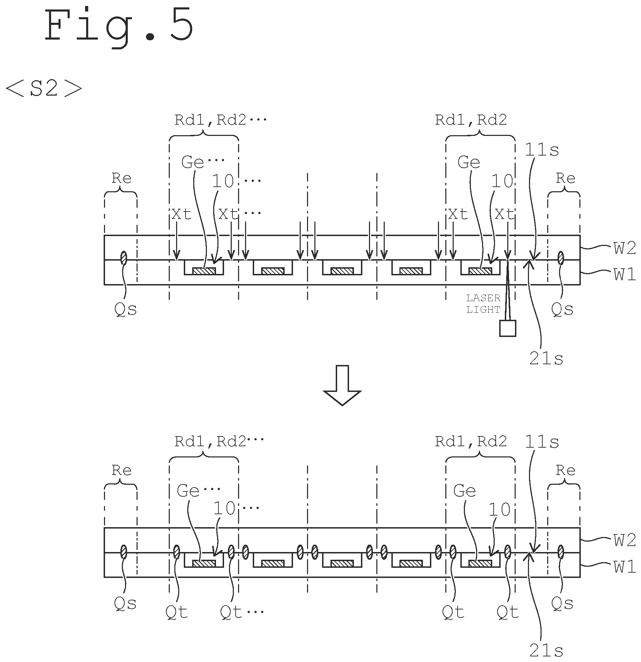

FIG. 5 is a conceptual view showing the permanent joining step S2 in a process sequence performed in the present embodiment. In the present embodiment, the first joining target W1 and the second joining target W2 after the provisional joining are taken out of the chamber 30, and these joining targets are subjected to the permanent joining step S2 described below in an atmospheric pressure. In the present embodiment, the permanent joining step S2 is performed using a chamber different from the chamber 30 having been used for implementation of the provisional joining step S1. These chambers may be constructed in a single one apparatus, or may be constructed separately in different apparatuses.

Here, according to the above provisional joining step S1, the interior of the ring shape of the fixing part Qs is sealed at a pressure equal or substantially equal to the internal pressure intended value Px. Thus, by exposing the first joining target W1 and the second joining target W2 after the provisional joining to an atmospheric pressure, a pressure difference can be generated between a pressure in the ring shape (an internal pressure) and a pressure outside the ring shape (an external pressure). Thus, in a region inside the ring shape of the fixing part Qs, the first joining target W1 and the second joining target W2 can become interposed under pressure from back surface sides using the generated pressure difference. Such interposing under pressure by means of the pressure difference allows the joint surfaces 11s and 21s to tightly contact each other in the region inside the ring shape of the fixing part Qs. The permanent joining step S2 is performed in a state where the joint surfaces 11s and 21s are brought into tight contact with each other in this way.

In the permanent joining step S2, the first joining target W1 and the second joining target W2 are fixed further to each other in the region inside the ring shape of the fixing part Qs formed in the provisional joining step S1.

More specifically, for each pair of the corresponding device regions Rd1 and Rd2 (the device regions Rd1 and Rd2 at positions matched with each other by the alignment), a fixing part Qt is formed for sealing a cavity (a cavity before sealing) formed in that pair of regions. At this time, the fixing part Qt is formed into a ring shape (a closed ring shape) surrounding the recess part 10 constituting each cavity.

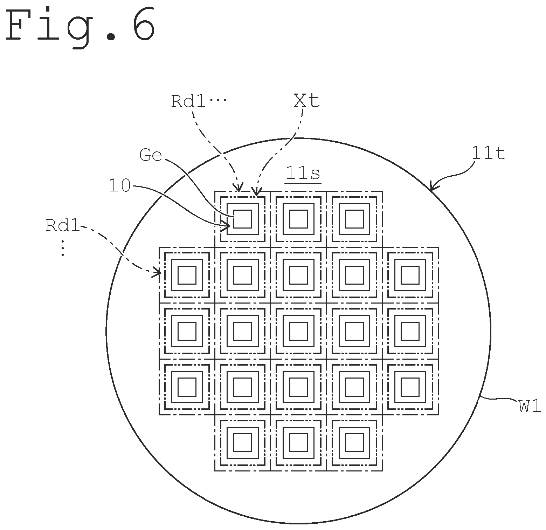

More specifically, laser light is applied locally to the interface (the contact surface) between the joint surfaces 11s and 21s in the region inside the fixing part Qs (see an upper view of S2 shown in FIG. 5), so that a site applied with the laser light is heated locally to be melted or altered. By doing so, the joint surfaces 11s and 21s are fixed to each other at the local site (see a lower view of S2 shown in FIG. 5). At this time, the first joining target W1 and the second joining target W2 may be interposed under pressure using quartz plates, for example, in order to further increase a degree of tight contact between the joint surfaces 11s and 21s. Then, scan is performed with laser light along a pattern of the closed ring shape (a planned formation pattern Xt of the fixing part Qt, see FIG. 6), thereby fixing the joint surfaces 11s and 21s to each other along the pattern. In this way, the fixing part Qt with the closed ring shape is formed for the corresponding device regions Rd1 and Rd2.

FIG. 6 is a plan view illustrating the planned formation pattern Xt of the fixing part Qt. In the example in FIG. 6, each device region Rd1 has a quadrangular shape (the device region Rd2 corresponding to each device region Rd1 also has a quadrangular shape), and the planned formation pattern Xt is defined into a quadrangular shape along a periphery of the device region Rd1 and into a ring shape surrounding the recess part 10. The shape of the planned formation pattern Xt is not limited to the quadrangular ring shape but may be changed, as appropriate, to a ring shape of a different form (such as a circular or polygonal form) in response to the peripheral shape of each device region Rd1 or an opening shape of the recess part 10.

As described above, in the provisional joining step S1, a state where the interior of the cavity (the cavity before sealing) has been reduced to the internal pressure intended value Px is created efficiently. Thus, in the permanent joining step S2, it is possible to easily provide the cavity (the cavity after sealing) where an internal pressure is maintained at an appropriate value (the internal pressure intended value Px) simply by performing joining for sealing the cavity (the cavity before sealing) in the way described above.

In the present embodiment, the permanent joining step S2 is performed using a chamber different from the chamber 30 having been used for implementation of the provisional joining step S1. This makes it possible to shorten cycle time required for processes (provisional joining and permanent joining) on one set of joining targets (the first joining target W1 and the second joining target W2). This will be described below in detail.

Both the stacking step S11 (a step where an atmosphere at a pressure lower than the predetermined pressure Pt(an atmosphere where a degree of vacuum is high, for example) is required to be created) of the provisional joining step S1 and the permanent joining step S2 are processes to take time. Here, it is assumed that the provisional joining step S1 and the permanent joining step S2 are performed sequentially in one chamber. In this case, a transition to the processes on a next set of joining targets can be made only after the processes on one set of joining targets are finished, leading to longer cycle time required for the processes (provisional joining and permanent joining) on one set of joining targets.

By contrast, according to the manufacturing method of the present embodiment, by performing the permanent joining step S2 using a chamber different from the chamber 30 used for implementation of the provisional joining step S1, it becomes possible to perform these steps in parallel using a plurality of chambers. As a result, cycle time required for the processes (provisional joining and permanent joining) on one set of joining targets can be shortened.

### [2] Modifications

### [2-1] First Modification

As long as the planned formation pattern Xs of the fixing part Qs used in the provisional joining step S1 has a ring shape capable of surrounding a plurality of the device regions Rd1, it may be changed, as appropriate, to a ring shape of a different form not limited to the shape illustrated in FIG. 4 (the ring shape along the outer peripheral edge 11t).

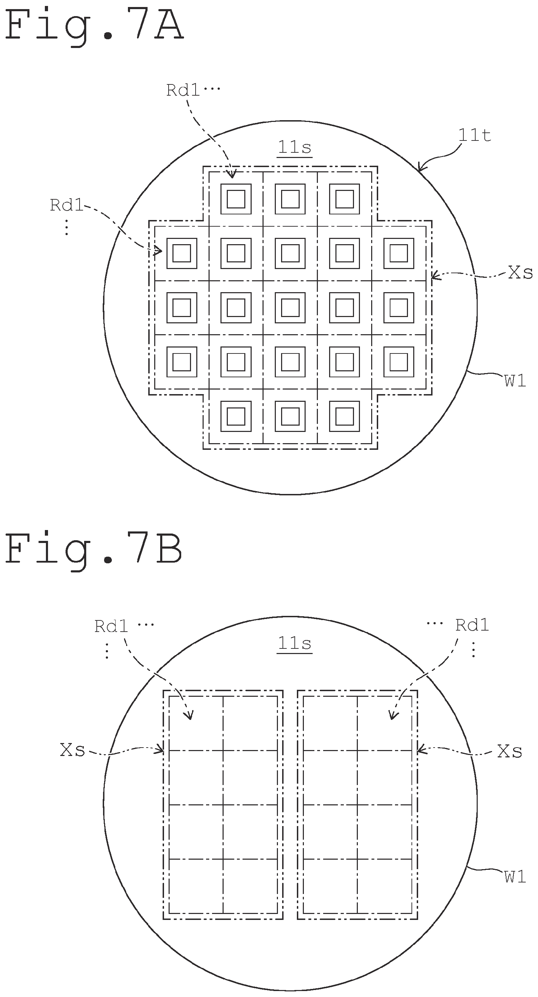

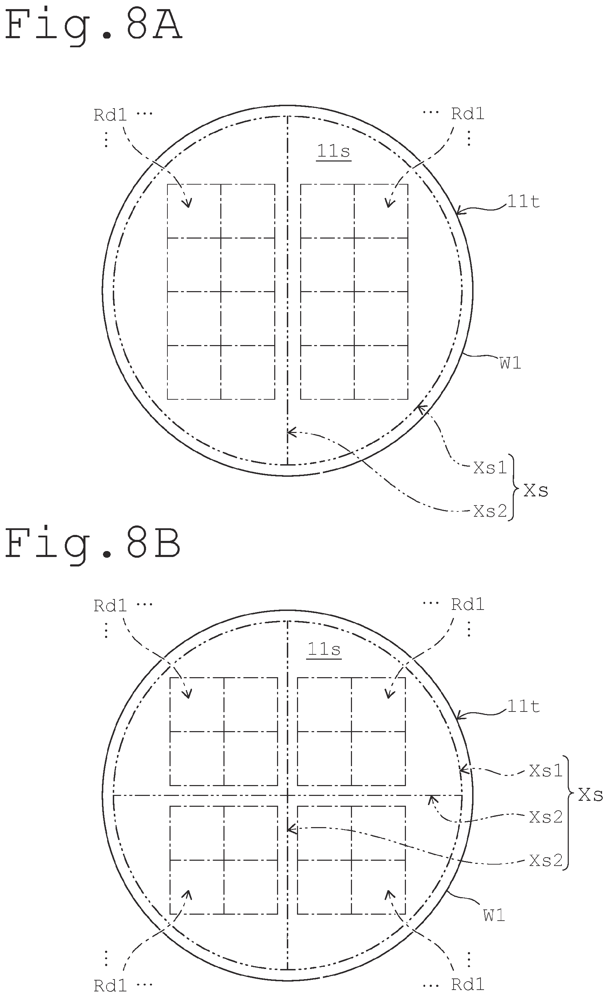

FIGS. 7A and 7B are plan views showing two examples of the planned formation pattern Xs of the fixing part Qs used in a first modification. FIGS. 8A and 8B are plan views showing other two examples of the planned formation pattern Xs of the fixing part Qs used in the first modification.

In FIG. 7A, the planned formation pattern Xs is defined into a ring shape surrounding all the device regions Rd1 of the first joining target W1 along outermost edges thereof.

Meanwhile, in each of FIGS. 7B to 8B, the device regions Rd1 are divided into some groups, and for each group, the planned formation pattern Xs is defined into a ring shape surrounding all the device regions Rd1 in this group. In FIG. 7B, the planned formation pattern Xs is defined into an independent ring shape for each group. Meanwhile, in FIGS. 8A and 8B, the planned formation pattern Xs is defined by combining a circular pattern Xs1 and a linear pattern Xs2 in such a manner as to allow a part of the ring shape to be shared between the groups. This will be described below in detail.

In FIG. 8A, the planned formation pattern Xs is composed of the circular pattern Xs1 defined into a ring shape along the outer peripheral edge 11t, and one linear pattern Xs2 crossing the interior of the circular pattern Xs1. In this case, a part of the planned formation pattern Xs corresponding to the linear pattern Xs2 is shared between the groups. As a result, the planned formation pattern Xs includes two semicircular ring shapes in order for the gropes, for each group, to be capable of surrounding all the device regions Rd1 in this group.

In FIG. 8B, the planned formation pattern Xs is composed of the circular pattern Xs1 defined into a ring shape along the outer peripheral edge 11t, and two linear patterns Xs2 crossing the interior of the circular pattern Xs1 and intersecting each other (in the example in FIG. 8B, orthogonal to each other). In this case, parts of the planned formation pattern Xs corresponding to the linear patterns Xs2 are also shared between the groups. As a result, the planned formation pattern Xs includes four sector ring shapes in order for the gropes, for each group, to be capable of surrounding all the device regions Rd1 in this group.

### [2-2] Second Modification

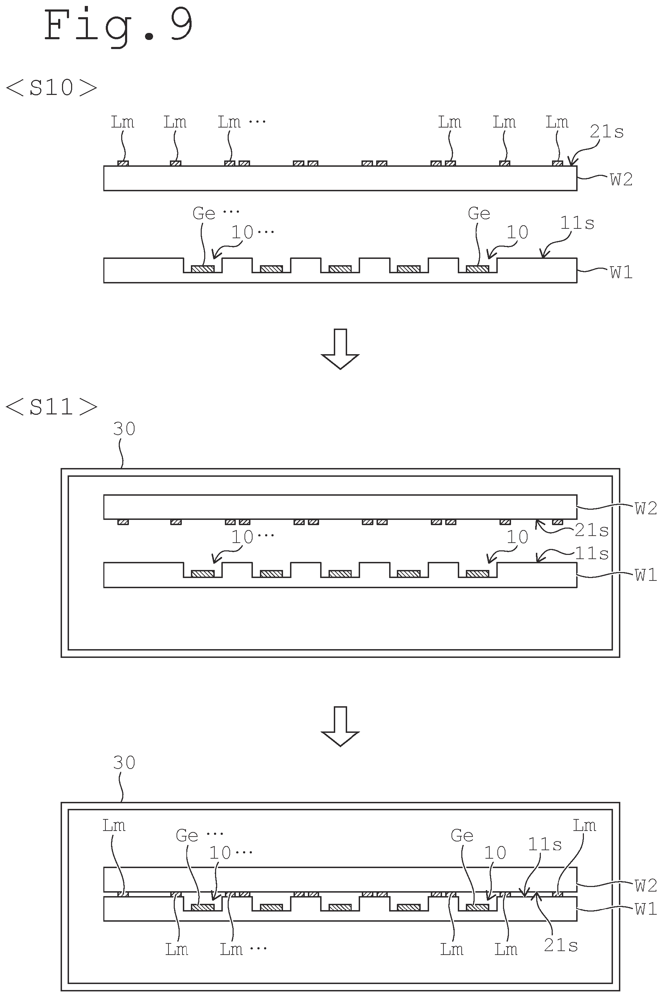

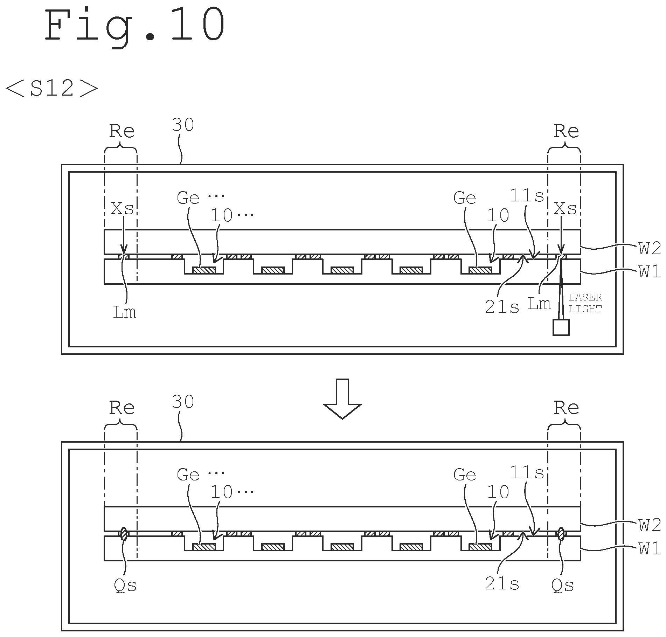

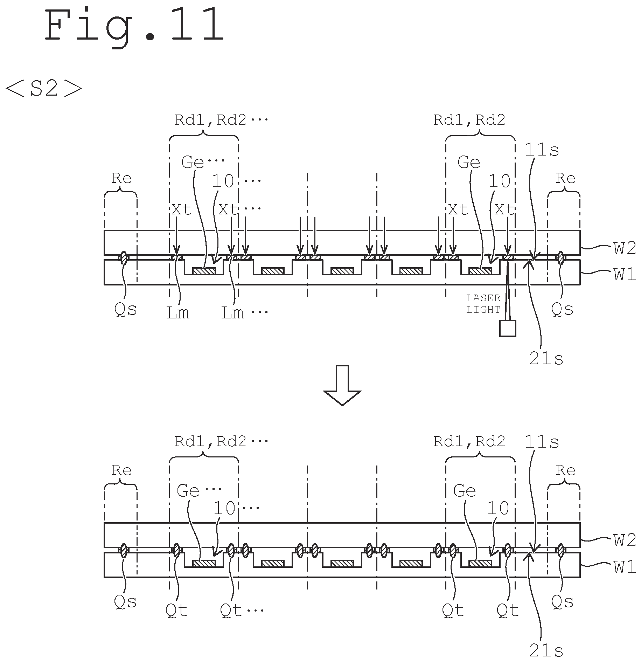

FIGS. 9 and 10 are conceptual views showing the provisional joining step S1 in a process sequence performed in a second modification. FIG. 11 is a conceptual view showing the permanent joining step S2 in a process sequence performed in the second modification.

As shown in FIG. 9, in the preparing step S10, at least one of the joint surface 11s of the first joining target W1 and the joint surface 21s of the second joining target W2 may be provided with a metal layer Lm (a metal layer forming step). The example in FIG. 9 shows a case where the metal layer Lm is formed only at sites where the fixing parts Qs and Qt are to be formed (see FIGS. 10 and 11) on the joint surface 21s on the side of the second joining target W2. More specifically, the metal layer Lm is formed at a site separated from electrodes, interconnect lines, or the like to be electrically connected to each other during joining between the first joining target W1 and the second joining target W2 (a site available for forming the metal layer Lm in a state of being in electrically non-contact with the electrodes, the interconnect lines, or the like).

While not particularly limited, the metal layer Lm is formed into a thickness of equal to or less than 1 µm using a film deposition method such as a vapor deposition method. Metal such as Cu, Al, Cr, Ti, Ta, or Au may be used as a main component of the metal layer Lm.

The metal layer Lm may be formed on the joint surface 11s on the side of the first joining target W1. The metal layer Lm may be formed on each of the joint surfaces 11s and 21s. In this case, two types of metal layers Lm containing respective main components which differ from each other may be formed on the joint surfaces 11s and 21s. If there is no need to form electrical connection between electrodes, interconnect lines, or the like during joining between the first joining target W1 and the second joining target W2, the metal layer Lm may be formed in an entire area in at least one of the joint surfaces 11s and 21s.

In the present modification, the metal layer Lm is used for forming the fixing parts Qs and Qt in the fixing part forming step S12 (see FIG. 10) and the permanent joining step S2 (see FIG. 11). More specifically, laser light is applied locally to the metal layer Lm provided between the first joining target W1 and the second joining target W2, so that sites applied with the laser light are heated locally to form the fixing parts Qs and Qt with ring shapes.

More specifically, by the application of the laser light to the metal layer Lm (see views of S12 and an upper view of S2 shown in FIGS. 10 and 11 respectively), at the sites applied with the laser light (sites where the fixing parts Qs and Qt are planned to be formed, in other words, the planned formation patterns Xs and Xt), it is possible to melt the metal layer Lm together with the first joining target W1 and the second joining target W2 or diffuse the metal as the main component of the metal layer Lm into the first joining target W1 and the second joining target W2. As a result, a compound (such as metal silicide) or an alloy (such as an alloy of metal and Si) between the metal and the main component (such as semiconductor) of each of the first joining target W1 and the second joining target W2 is formed at an interface between the metal layer Lm and each of the first joining target W1 and the second joining target W2. In other words, it is possible to form the fixing parts Qs and Qt for firmly coupling the first joining target W1 and the second joining target W2 to each other (see the views of S12 and a lower view of S12 shown in FIGS. 10 and 11 respectively).

In the provisional joining step S1, the resultant fixing part Qs is formed into a ring shape (a closed ring shape) in an atmosphere at a pressure lower than the predetermined pressure Pt, so that the interior of the ring shape can be sealed reliably while being maintained at the lower pressure than the predetermined pressure Pt.

### [2-3] Third Modification

The permanent joining step S2 is not limited a case where it is performed at an atmospheric pressure but may be performed in an atmosphere pressurized in a chamber. This configuration makes it possible to increase a pressure difference between a pressure inside the ring shape (an internal pressure) and a pressure outside the ring shape (an external pressure) to eventually allow the first joining target W1 and the second joining target W2 to be interposed under pressure with larger force in the region inside the ring shape of the fixing part Qs. Thus, even if there is a distortion at the first joining target W1 or the second joining target W2, it is still possible to form tight contact between the joint surfaces 11s and 21s by correcting the distortion.

### [2-4] Fourth Modification

The above joining method is not limited to a case where it is employed for joining between two joining targets (the first joining target W1 and the second joining target W2) for the purpose of forming a cavity but may be employed further to a case where the two joining targets are to be joined to each other for various types of other purposes. In such cases, it is also possible to form tight contact between the first joining target W1 and the second joining target W2 by means of a pressure difference between a pressure inside the ring shape (an internal pressure) and a pressure outside the ring shape (an external pressure). Furthermore, by performing the permanent joining step S2 using a chamber different from the chamber 30 used for implementation of the provisional joining step S1, it becomes possible to shorten cycle time required for the processes (provisional joining and permanent joining) on one set of joining targets.

Moreover, the above joining method is further applicable to a case where two joining targets not provided with the device region Rd1 or Rd2 are to be joined to each other. In this case, it is also possible to form tight contact between the two joining targets or shorten cycle time.

### [2-5] Fifth Modification

According to the above joining method of the present embodiment, in order to efficiently create a state where an internal pressure in the cavity has been reduced to the intended internal pressure (the internal pressure intended value Px), the process of superposing two joining targets (the first joining target W1 and the second joining target W2) on each other in an atmosphere at a pressure lower than the predetermined pressure Pt is performed in the stacking step S11. Instead of this, according to the present modification, in order to efficiently create a state where the cavity is filled with desired gas (mainly, an inert gas such as nitrogen gas, neon gas, or argon gas), the following process is performed in the provisional joining step S1.

In the provisional joining step S1 of the present modification, after implementation of the preparing step S10 same as that of the above embodiment, a replacing step S31, a stacking step S32, and a fixing part forming step S33 are performed in this sequence.

### <Replacing Step S31>

In the replacing step S31, first, the first joining target W1 and the second joining target W2 are introduced into the chamber 30 to which gas can be injected and where an internal pressure can be regulated. At this time, the first joining target W1 and the second joining target W2 are located in the chamber 30 with the respective joint surfaces 11s and 21s thereof facing each other and being separated from each other (see the upper view of S11 shown in FIG. 1).

Next, an internal pressure in the chamber 30 is reduced to generate a vacuum (a state where a pressure has been reduced to a desired degree of vacuum) inside the chamber 30. Then, gas (this gas will be called "predetermined gas") of the same type as the desired gas for filling in the cavity (mainly, an inert gas such as nitrogen gas, neon gas, or argon gas) is injected into the chamber 30, thereby replacing the interior of the chamber 30 with an atmosphere filled with the predetermined gas. At this time, an internal pressure in the chamber 30 can be regulated, and may be regulated to a negative pressure lower than an atmospheric pressure or may be regulated to a positive pressure higher than an atmospheric pressure.

According to the described replacing step S31, by injecting the predetermined gas into the chamber 30 after a vacuum is generated in the chamber, the interior of the chamber 30 is replaced easily with an atmosphere containing the predetermined gas as a main component.

### <Stacking Step S32>

In the stacking step S32, the second joining target W2 is superposed on the first joining target W1 in the atmosphere filled with the predetermined gas. Furthermore, like in the above embodiment, position alignment is made on at least one of the first joining target W1 and the second joining target W2 in order for the respective positions of the corresponding device regions Rd1 and Rd2 to be matched with each other. Then, while the positional relationship after the alignment is maintained, the second joining target W2 is superposed on the first joining target W1 (see the lower view of S11 shown in FIG. 1).

A method conventionally employed for creating a state filled with the desired gas in the cavity includes the following.
(1) First, two joining targets are aligned with each other in terms of a positional relationship therebetween and then superposed on each other.
(2) Next, provisional joining is performed for maintaining the adjusted positional relationship.
(3) The two joining targets are thereafter introduced into a chamber, and then a vacuum is generated in the chamber.
(4) Next, the interior of the chamber is filled with gas (predetermined gas) of the same type as the desired gas.
(5) Finally, permanent joining is performed for sealing the cavity inside the chamber.

According to this conventional method, by means of a differential pressure (a state where an internal pressure is larger than an external pressure) resulting from generating a vacuum in the chamber in (3), air in the cavity is caused to flow out to the outside through a gap between joint surfaces of the two joining targets (a part except a provisionally-joined site), thereby trying to generate a vacuum further in the cavity. As already described, however, once the two joining targets are superposed on each other, it is considered that a large flow path resistance occurs in the gap between the joint surfaces even if the differential pressure is generated, thereby imposing difficulty in causing air to flow out to the outside through the gap between the joint surfaces.

By means of a differential pressure (a state where an external pressure is larger than an internal pressure) resulting from filling the interior of the chamber with the predetermined gas in (4), the gas in the chamber is caused to flow internally through the gap between the joint surfaces of the two joining targets (the part except the provisionally-joined site), thereby trying to fill the interior of the cavity with the predetermined gas. In this case, however, it is also considered that the large flow path resistance in the gap between the joint surfaces imposes difficulty in causing the gas to flow internally through the gap between the joint surfaces.

By contrast, according to the stacking step S32 of the present modification, by the simple method of superposing the two joining targets (the first joining target W1 and the second joining target W2) on each other in the atmosphere filled with the predetermined gas, a state filled with the same gas as that in the atmosphere at this moment can be created in the cavity before sealing formed in the stacking step S32. Moreover, by simply selecting a type of the gas for filling the interior of the chamber 30, a state filled with the desired gas can be created in the cavity before sealing. By doing so, it is possible to efficiently create a state where the cavity (here, the cavity before sealing) is filled with the desired gas. In this way, according to the stacking step S32, it is possible to efficiently control a state in the cavity before sealing.

### <Fixing Part Forming Step S33>

In the fixing part forming step S33, like in the above embodiment, while the atmosphere in the chamber 30 is maintained as it is (in other words, while the atmosphere filled with the predetermined gas is maintained), the fixing part Qs for fixing the second joining target W2 to the first joining target W1 is formed into a ring shape (a closed ring shape) along the outer peripheral edge 11t of the first joining target W1, thereby sealing the interior of the ring shape (see the lower view of S12 shown in FIG. 2, and FIG. 4).

According to the described fixing part forming step S33, in a state where the atmosphere in the chamber 30 is maintained (in other words, in a state where the atmosphere filled with the predetermined gas is maintained), the fixing part Qs is formed into the ring shape (the closed ring shape), thereby sealing the interior of the ring shape. By doing so, even if the first joining target W1 and the second joining target W2 after the provisional joining are exposed to air, it is still possible to maintain the interior of the ring shape in the state filled with the desired gas.

The configurations of the first to fourth modifications described above are further applicable to the present modification.

### [2-6] Other Modifications

The metal layer forming step constituting a part of the preparing step S10 may be performed in the chamber 30 where the stacking step S11 is performed.

If there is no need to shorten cycle time or if there is great need to complete the processes (provisional joining and permanent joining) in one chamber, for example, the permanent joining step S2 may be performed in the same chamber as the chamber 30 used for implementation of the provisional joining step S1.

In the absence of need for a high degree of accuracy in a positional relationship between two joining targets during joining, which is to occur if the joining targets are not provided with interconnect lines, electrodes, or the like to be connected to each other during joining or if the device region Rd1 or Rd2 is not provided, for example, the above joining method may be changed, as appropriate, to a joining method of performing joining without making alignment in the stacking step S11.

The above explanations of the embodiment and the modifications are nothing more than illustrative in any respect, nor should be thought of as restrictive. The scope of the present invention is indicated by claims rather than the above embodiment and modifications. Furthermore, it is intended that all changes that are equivalent to a claim in the sense and realm of the doctrine of equivalence be included within the scope of the present invention.

Some of the steps constituting the joining method may be extracted partially as subjects of the invention or each of the steps may be extracted individually as a subject of the invention from the above embodiment and modifications. For example, the provisional joining step S1 and the permanent joining step S2 may be extracted individually as subjects of the invention.

### Reference Signs List

10 Recess part
11s, 21s Joint surface
11t Outer peripheral edge
30 Chamber
Ct Cutting line
Ge Element
Lm Metal layer
Pt Predetermined pressure
Px Internal pressure intended value
Rd1, Rd2 Device region
Qs, Qt Fixing part
Re Peripheral portion
W1 First joining target
W2 Second joining target
Xs, Xt Planned formation pattern
Xs1 Circular pattern
Xs2 Linear pattern
S1 Provisional joining step
S2 Permanent joining step
S10 Preparing step
S11 Stacking step
S12 Fixing part forming step
S31 Replacing step
S32 Stacking step
S33 Fixing part forming step

## Claims

1. A joining method comprising:
a stacking step that superposes a first joining target and a second joining target on each other in an atmosphere at a pressure lower than a predetermined pressure; and
a fixing part forming step that forms a fixing part for fixing the second joining target to the first joining target while maintaining the atmosphere after the stacking step, the fixing part being formed into a ring shape along an outer peripheral edge of the first joining target, thereby sealing the interior of the ring shape.

2. A joining method comprising:
a stacking step that superposes a first joining target and a second joining target on each other in an atmosphere at a pressure lower than a predetermined pressure, the first joining target being provided with a plurality of device regions; and
a fixing part forming step that forms a fixing part for fixing the second joining target to the first joining target while maintaining the atmosphere after the stacking step, the fixing part being formed into a ring shape surrounding the plurality of device regions, thereby sealing the interior of the ring shape.

3. The joining method according to claim 2, wherein
each of the device regions of the first joining target is provided with a recess part to become a cavity, and
in the stacking step, an atmosphere where a pressure has been reduced to a value equal or approximate to an internal pressure intended value for the cavity is used as the atmosphere.

4. A joining method comprising:
a replacing step that generates a vacuum in a chamber where a first joining target and a second joining target are located and then injects predetermined gas into the chamber, thereby replacing the interior of the chamber with an atmosphere filled with the predetermined gas;
a stacking step that superposes the first joining target and the second joining target on each other in the atmosphere filled with the predetermined gas; and
a fixing part forming step that forms a fixing part for fixing the second joining target to the first joining target while maintaining the atmosphere filled with the predetermined gas after the stacking step, the fixing part being formed into a ring shape along an outer peripheral edge of the first joining target, thereby sealing the interior of the ring shape.

5. A joining method comprising:
a replacing step that generates a vacuum in a chamber where a first joining target provided with a plurality of device regions and a second joining target are located and then injects predetermined gas into the chamber, thereby replacing the interior of the chamber with an atmosphere filled with the predetermined gas;
a stacking step that superposes the first joining target and the second joining target on each other in the atmosphere filled with the predetermined gas; and
a fixing part forming step that forms a fixing part for fixing the second joining target to the first joining target while maintaining the atmosphere filled with the predetermined gas after the stacking step, the fixing part being formed into a ring shape surrounding the plurality of device regions, thereby sealing the interior of the ring shape.

6. The joining method according to any one of claims 2, 3, and 5, wherein
the second joining target is provided with device regions corresponding to the device regions of the first joining target, and
in the stacking step, position alignment is made on at least one of the first joining target and the second joining target in order for the respective positions of the corresponding device regions to be matched with each other, and the second joining target is superposed on the first joining target after the alignment.

7. The joining method according to any one of claims 1 to 6, further comprising:
a metal layer forming step that forms a metal layer on at least one of a joint surface of the first joining target and a joint surface of the second joining target before the stacking step, wherein
in the fixing part forming step, laser light is applied locally to the metal layer provided between the first joining target and the second joining target, so that a site applied with the laser light is heated locally to form the fixing part with the ring shape.

8. A joining method comprising:
a provisional joining step that performs provisional joining between a first joining target and a second joining target using the joining method according to any one of claims 1 to 7; and
a permanent joining step that fixes the first joining target and the second joining target further to each other in a region inside the ring shape of the fixing part after the provisional joining step, wherein
the permanent joining step is performed using a chamber different from a chamber used for implementation of the provisional joining step.
